# EUROPÄISCHE PATENTANMELDUNG

(11) **EP 0 865 075 A2**
(43) Veröffentlichungstag der Anmeldung: **16.09.1998**
(21) Anmeldenummer: 98102579.4
(22) Anmeldetag: 14.02.1998
(51) Int. Cl.: H01L 21/24, H01L 21/48, H01L 21/60

(54) **Verfahren zum Herstellen von räumlich strukturierten Bauteilen**

(30) Priorität: 13.03.1997 DE 19710375
(71) Anmelder: Micronas Intermetall GmbH, 79108 Freiburg (DE)
(72) Erfinder: Igel, Günther, Dipl.-Ing., 79331 Teningen (DE); Mall, Martin, Dr. Dipl.-Phys., 79100 Freiburg (DE)
(74) Vertreter: Hornig, Leonore, Dr.

(57) **Zusammenfassung**

Die Erfindung betrifft ein Verfahren zum Herstellen von räumlich strukturierten Bauteilen 10 aus einem Körper 1, bei dem auf der Rückseite des Körpers 1 eine Verzögerungsschicht 8 mit Durchbrechungen 9 zum Verzögern eines Abtragvorgangs des Materials des Körpers vorgesehen wird, auf der Rückseite des Körpers 1 Gebiete 5 aus einem migrationsfähigen Material aufgebracht werden, der Körper 1 einem thermischen Migrationsverfahren unterzogen wird, so daß Migrationsbereiche 7 entstehen, und dann die Bauteile 10 in einem einzigen Abtragvorgang aus dem Körper 1 herausgetrennt und die Migrationsbereiche 7 freigelegt werden.

## Beschreibung

Die Erfindung betrifft ein Verfahren zum Herstellen von räumlich strukturierten Bauteilen aus einem Körper.

Ein technischer Bereich, in dem Bauteile aus einem Körper hergestellt werden, ist die Halbleitertechnik. Dort werden elektronische Elemente aus einem Halbleiterwafer vereinzelt.

In der DE 43 17 721 ist ein solches Verfahren zum Vereinzeln von Chips aus einem Wafer bekannt. Der Wafer weist eine SOI-Schicht auf. Zwischen den Chips werden Gräben bis zu der Isolatorschicht geätzt, dann werden Spacer zur Passivierung von Siliziumoxid-Schichten der Chips hergestellt und danach die Chips durch Wegätzen der Isolatorschicht vereinzelt.

Ferner ist aus der nicht vorveröffentlichten deutschen Patentanmeldung Nr. 195 38 634.5 ein Verfahren zum Vereinzeln von elektronischen Elementen aus einem Halbleiterwafer bekannt. Bei diesem Verfahren erfolgt das Trennen der elektronischen Elemente durch Abtragen von Material in Trennbereichen des Halbleiterwafers, wobei innerhalb eines abzudünnenden Bereiches des Halbleiterwafers eine Verzögerungsschicht vorgesehen ist, die den Abtragvorgang verzögert und in den Trennbereichen Durchbrechungen aufweist. Bei diesem Verfahren können auch sehr dünne elektronische Elemente aus einem relativ dicken Halbleiterwafer, welche aus Stabilitätsgründen üblich sind, einfach herausgetrennt werden. Die Dicke des Halbleiterwafers wird gleichzeitig mit dem Trennvorgang reduziert. Das Trennen der Elemente erfolgt gleichzeitig durch Abtragen des Materials in den Trennbereichen des Halbleiterwafers. Das Material der Verzögerungsschicht ist dabei so gewählt, daß das Abtragen des Materials verlangsamt wird, so daß die Dicke des Körpers langsamer reduziert wird als der Trennvorgang der Elemente vor sich geht.

Aus Schade, 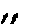 Halbleitertechnologie Band 2", Verlag Technik, Berlin 1983, Seite 21 ff ist es bekannt, in einem Halbleiter Strukturen aus migrationsfähigem Material auszubilden. Es wird hierzu ein migrationsfähiges Material, beispielsweise Aluminium, mittels Dünnschichtverfahren auf den Halbleiter aufgebracht. Durch ein Migrationsverfahren, bei dem ein bestimmter Temperaturgradient an den Halbleiterwafer angelegt wird, wandert das Material aus der Schicht entlang des Temperaturgradienten in den Halbleiter. Mit diesem Verfahren können sowohl abrupte pn-Übergänge und Anreicherungsgebiete als auch Leiterbahnen durch den Halbleiter hindurch erzeugt werden.

Für verschiedene Anwendungen kann es wünschenswert sein, räumlich strukturierte Bauteile herzustellen. In der Halbleitertechnik können derartige Bauteile beispielsweise als Kühlkörper verwendet werden. Sie können separat hergestellt und auf elektronische Elemente aufgebracht werden. Es ist jedoch aufwendig geeignet strukturierte Bauteile, wie Mikrokühleinrichtungen, herzustellen und diese mit elektronischen Elementen zu verbinden.

Auch ist es aus der Praxis bekannt, elektronische Elemente mit einer Kühleinrichtung dadurch herzustellen, daß die Rückseite des Wafers durch Einbringen von Sägespuren strukturiert wird, um deren Oberfläche zu vergrößern. Dieses Verfahren hat jedoch den Nachteil, daß aufgrund des Sägens der Wafer mechanisch instabil wird, und daß sich durch die Strukturierung der Wafer verbiegen kann.

Der Erfindung liegt die Aufgabe zugrunde, ein einfaches Verfahren zum Herstellen von räumlich strukturierten Bauteilen ohne die oben genannten Nachteile zu schaffen.

Diese Aufgabe wird durch ein Verfahren zum Herstellen von räumlich strukturierten Bauteilen aus einem Körper gelöst, bei dem auf der Rückseite des Körpers eine Verzögerungsschicht zum Verzögern eines Abtragvorgangs des Materials des Körpers vorgesehen wird, die in Trennbereichen zum Trennen der Bauteile Durchbrechungen aufweist, auf die Rückseite des Körpers eine Schicht aus einem migrationsfähigen Material aufgebracht und so strukturiert wird, daß wenigstens ein Gebiet aus dem migrationsfähigen Material pro Bauteil auf der Rückseite des Körpers entsteht, der Körper einem Migrationsverfahren unterzogen wird, dessen Parameter derart gewählt werden, daß ein Teil des migrationsfähigen Materials bis zu einem vorgegebenen Bereich in der Nähe der Vorderseite des Körpers gelangt, wodurch in dem Körper Migrationsbereiche entstehen, und dann in einem einzigen Abtragvorgang die Bauteile aus dem Körper herausgetrennt und die Migrationsbereiche oder das zwischen den Migrationsbereichen liegende Material freigelegt werden.

Bei dem erfindungsgemäßen Verfahren werden Bauteile gebildet, die aufgrund der freigelegten Migrationsbereiche strukturiert sind. Diese Bauteile können in einem einzigen Abtragvorgang aus dem Körper herausgetrennt werden. Bei dem Abtragvorgang wird das Abtragen des Materials in den Migrationsbereichen und dort, wo die Verzögerungsschicht vorhanden ist, verzögert. Es wird somit das Material in den Trennbereichen zwischen den Bauteilen abgetragen. Abhängig von dem Material der Migrationsbereiche, d.h. abhängig davon, ob es eine niedrigere oder eine höhere Abtragsrate aufweist als das Material des Körpers, wird gleichzeitig das Material zwischen den Migrationsbereichen oder das Material in den Migrationsbereichen abgetragen. Es entstehen somit Bauelemente einer vorgegebenen Dicke die zusätzlich eine durch die Migrationsbereiche vorgegebene Struktur aufweisen.

Da das Trennen und Strukturieren der Bauelemente in einem Abtragvorgang erfolgt, treten in dem Wafer keine mechanischen Spannungen, wie durch eine mechanische Bearbeitung, auf. Ferner wird die Stabilität des Wafers während des Herstellungsverfahrens nicht beeinträchtigt.

Günstigerweise erfolgt das Abtragen des Materials des Körpers durch Ätzen, insbesondere durch Plasmaätzen. Es ist vorteilhaft, wenn das migrationsfähige Material hinsichtlich des Abtragvorgangs eine niedrigere Abtragsrate als das Material des Körpers aufweist. Dann bleiben nach dem Heraustrennen der Bauteile die Migrationsbereiche erhalten und bilden eine räumliche Struktur der Bauteile. Das Material der Migrationsschicht kann ein Metall, insbesondere Aluminium sein.

Gemäß einem bevorzugten Ausführungsbeispiel ist der Körper ein Halbleiterwafer, auf dessen Vorderseite aktive Bereiche ausgebildet sind, wobei als Bauteile elektronische Elemente hergestellt werden. In diesem Fall werden elektronische Elemente mit einer räumlichen Struktur erzeugt. Dies ist etwa dann vorteilhaft, wenn elektronische Elemente gekühlt werden müssen, weil die so erzeugten elektronischen Elemente bereits eine Mikrokühleinrichtung aufweisen, die nicht in einem separaten Vorgang mit den elektronischen Elementen verbunden werden muß In weiteren Anwendungsfällen können die Migrationsbereiche als elektrische Kontaktanschlüsse oder als Kondensatorelektroden verwendet werden.

In die Zwischenräume von den einem Bauelement zugeordneten Migrationsbereichen kann ein von dem Material des Körpers verschiedenes Material eingebracht werden. Es kann beispielsweise als Dielektrikum zwischen Kondensatorelektroden oder als ein weiteres Material zum Ableiten von Wärme zwischen Kühlelementen dienen.

Ferner können die freigelegten Migrationsbereiche mit einer Beschichtung versehen werden. Das Material der Beschichtung wird ebenfalls abhängig von der Anwendung der Bauteile gewählt. Es kann auch auf die Rückseite der freigelegten Migrationsbereiche eine dem jeweiligen Bauteil zugeordnete Abdeckung aufgebracht werden. Dies ist beispielsweise dann vorteilhaft, wenn in die Zwischenräume der Migrationsbereiche ein flüssiges oder ein gasförmiges Material eingebracht wird und dieses nicht entweichen soll. Die Abdeckung kann im Fall von Halbleiterbauteilen dadurch realisiert werden, daß ein zweiter Halbleiterwafer auf die Rückseite des Halbleiterwafers, in dem die Bauteile ausgebildet werden, aufgebracht wird.

Im folgenden wird die Erfindung anhand der Zeichnung näher erläutert.

Es zeigen:
Fig. 1 bis 3 ein gemäß dem erfindungsgemäßen Verfahren hergestelltes räumlich strukturiertes Bauteil,
Fig. 4 ein weiteres Ausführungsbeispiel eines gemäß dem erfindungsgemäßen Verfahren hergestellten Bauteils und
Fig. 5 ein anderes gemäß dem erfindungsgemäßen Verfahren hergestelltes Bauteil.

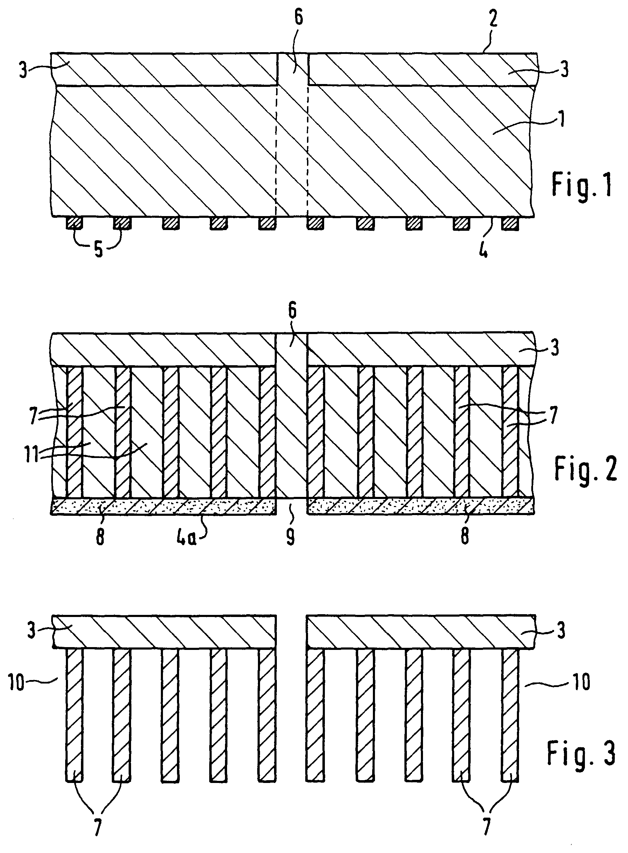

Fig. 1 zeigt einen Ausschnitt aus einem Körper 1, der einem Halbleiterwafer entspricht, im Querschnitt. Auf der Vorderseite 2 des Halbleiterwafers sind Hauptbereiche 3 der herzustellenden Bauteile gezeigt. Auf der Rückseite 4 des Halbleiterwafers ist eine Schicht aus migrationsfähigem Material aufgebracht und derart strukturiert, daß mehrere Gebiete 5 aus dem migrationsfähigen Material pro herzustellendem Bauteil auf der Rückseite 4 des Wafers entstehen. Zwischen den herzustellenden Bauteilen ist ein Trennbereich 6 zum Trennen der Bauteile definiert. Der Halbleiterwafer kann dabei aus Silizium und die Gebiete 5 des migrationsfähigen Materials können aus Aluminium bestehen. In diesem Zustand wird der Halbleiterwafer einem thermischen Migrationsverfahren unterzogen, dessen Parameter, insbesondere Temperaturgradient und Zeit, derart gewählt werden, daß das migrationsfähige Material in den Halbleiterwafer migriert, und zwar soweit, bis ein Teil des migrationsfähigen Materials bis zu einem vorgegebenen Bereich in der Nähe der Vorderseite 2 des Körpers 1 gelangt. Der vorgegebene Bereich ist hier durch den Hauptbereich 3 der Bauteile definiert. Es entstehen Migrationsbereiche 7, die in diesem Ausführungsbeispiel eine stabähnliche Struktur haben.

Dann wird gemäß Fig. 2 auf die Rückseite des Halbleiterwafers eine Verzögerungsschicht 8 zum Verzögern eines Abtragvorgangs des Materials des Halbleiterwafers mit Durchbrechungen 9 in den Trennbereichen 6 des Halbleiterwafers aufgebracht. Danach wird der Halbleiterwafer von der beschichteten Rückseite 4a ausgehend geätzt. Hierzu wird ein Ätzverfahren, bevorzugterweise ein Plasmaätzverfahren verwendet. Die Dicke und das Material der Verzögerungsschicht 8 sind so gewählt, daß an den Stellen, an denen die Verzögerungsschicht 8 keine Durchbrechung 9 aufweist, die lokale Ätzrate so verändert wird, daß die Hauptbereiche 3 der Bauteile 10 erhalten bleiben, während das Material des Halbleiterwafers aus den Trennbereichen 6 entfernt wird. Die Verzögerungsschicht 8 kann aus Siliziumoxid gebildet sein. Die Migrationsbereiche 7 wirken während des Ätzvorgangs als starke Verzögerungsschichten, so daß sie bei und nach dem Ätzverfahren im wesentlichen bestehen bleiben. Durch das Ätzverfahren werden also die Bauteile 10 aus dem Halbleiterwafer herausgetrennt und gleichzeitig strukturiert.

In Fig. 3 sind die räumlich strukturierten Bauteile 10, nachdem sie durch das Ätzverfahren aus dem Halbleiterwafer herausgetrennt worden sind, gezeigt. Sie bestehen aus den Hauptbereichen 3 und den Migrationsbereichen 7. Die Bauteile 10 können beispielsweise als Kühlelemente verwendet werden. Sie können auf elektronische Elemente aufgebracht werden. Es können aber auch in dem Halbleiterwafer in den Hauptbereichen 3 aktive Bereiche ausgebildet werden, so daß diese Elemente selbst als elektronische Elemente dienen, an denen bereits Migrationsbereiche 7 angebracht sind, die beispielsweise als Kühleinrichtung verwendet werden können.

Es sind Abwandlungen des beschriebenen Ausführungsbeispiels der Erfindung möglich. Beispielsweise kann zuerst die Verzögerungsschicht 8 auf die Rückseite 4 des Halbleiterwafers aufgebracht werden und danach auf der Verzögerungsschicht 8 die Gebiete 5 aus dem migrationsfähigen Material ausgebildet werden. Das Material und die Größe der Gebiete 5 aus dem migrationsfähigen Material muß dann so gewählt werden, daß es auch durch einen thermischen Migrationsprozeß durch die Verzögerungsschicht 8 hindurch migrieren kann. Es kann auch das migrationsfähige Material so gewählt werden, daß es eine größere Ätzrate als das Material des Körpers aufweist. In diesem Fall würden die zwischen den Migrationsbereichen 7 liegenden Zwischenbereiche 11 nach dem Ätzverfahren erhalten bleiben.

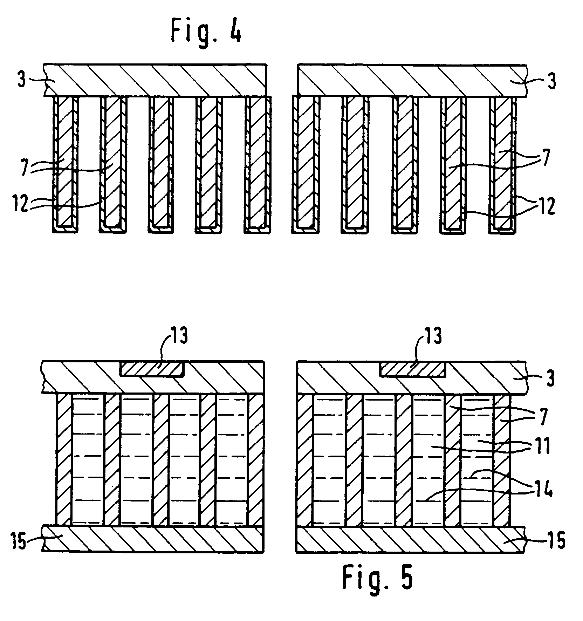

In Fig. 4 sind räumlich strukturierte Bauteile gezeigt, die gemäß dem in Zusammenhang mit dem in Fig. 1 bis 3 beschriebenen Verfahren hergestellt worden sind. In diesem Ausführungsbeispiel sind die freigelegten Migrationsbereiche 7 mit einer Beschichtung 12 versehen worden. Die Beschichtung 12 kann dabei so gewählt werden, daß sie die freigelegten Migrationsbereiche 7 verstärkt. Sie kann zu einer besseren Wärmeleitung führen.

In Fig. 5 ist ein Ausführungsbeispiel von Bauteilen 10 gezeigt, bei denen in dem Hauptbereich 3 aktive Bereiche 13 ausgebildet sind. Die Bauteile 10 sind somit elektronische Elemente. Die aktiven Bereiche 13 werden üblicherweise vor dem Aufbringen der Gebiete 5 aus migrationsfähigem Material und vor dem Aufbringen der Verzögerungsschicht 8 auf die Rückseite des Halbleiterwafers ausgebildet. Nach dem Trennen der Bauteile 10 gemäß dem im Zusammenhang mit Fig. 1 bis 3 beschriebenen Verfahren wird in die Zwischenbereiche 11 zwischen den Migrationsbereichen 7 ein von dem Material des Körpers und den Migrationsbereichen 7 verschiedenes Material 14 eingebracht. Auf die Rückseite der freigelegten Migrationsbereiche 7 wird eine dem jeweiligen Bauteil 10 zugeordnete Abdeckung 15 aufgebracht. Die Abdeckung 15 kann dabei durch Aufbringen eines weiteren Halbleiterwafers erzeugt werden. Das in die Zwischenbereiche 11 zwischen den Migrationsbereichen 7 eingebrachte Material kann fest, flüssig oder gasförmig sein. Die Abdeckung 15 kann auch vor dem Einbringen des Materials 14 in die Zwischräume auf die Rückseite der Migrationsbereiche 7 aufgebracht werden. Dies ist insbesondere dann zweckmäßig, wenn das Material 14 flüssig oder gasförmig ist. Das Material 14 kann zum besseren Ableiten von Wärme dienen. Die Migrationsbereiche 7 können auch als Kondensatorelektroden dienen, wobei das in die Zwischenbereiche 11 eingebrachte Material 14 als Dielektrikum wirkt.

## Patentansprüche

1. Verfahren zum Herstellen von räumlich strukturierten Bauteilen aus einem Körper (1),
bei dem auf der Rückseite (4) des Körpers (1) eine Verzögerungsschicht (8) zum Verzögern eines Abtragvorgangs des Materials des Körpers (1) vorgesehen wird, die in Trennbereichen (6) zum Trennen der Bauteile (10) Durchbrechungen (9) aufweist,
auf die Rückseite (4) des Körpers (1) eine Schicht aus einem migrationsfähigen Material aufgebracht und so strukturiert wird, daß wenigstens ein Gebiet (5) aus dem migrationsfähigen Material pro Bauteil (10) auf der Rückseite (4) des Körpers (1) entsteht,
der Körper (1) einem Migrationsverfahren unterzogen wird, dessen Parameter derart gewählt werden, daß ein Teil des migrationsfähigen Materials bis zu einem vorgegebenen Bereich in der Nähe der Vorderseite (2) des Körpers (1) gelangt` wodurch in dem Körper (1) Migrationsbereiche (7) entstehen,
und dann in einem einzigen Abtragvorgang die Bauteile (10) aus dem Körper (1) herausgetrennt und die Migrationsbereiche (7) oder das zwischen den Migrationsbereichen (7) liegende Material freigelegt wird.

2. Verfahren nach Anspruch 1, dadurch gekennzeichnet, daß das Abtragen des Materials des Körpers (1) durch Ätzen, insbesondere durch Plasmaätzen, erfolgt.

3. Verfahren nach einem der vorangehenden Ansprüche, dadurch gekennzeichnet, daß als migrationsfähiges Material ein Metall verwendet wird.

4. Verfahren nach einem der vorangehenden Ansprüche, dadurch gekennzeichnet, daß der Körper (1) ein Halbleiterwafer ist, auf dessen Vorderseite (2) aktive Bereiche (13) ausgebildet sind und als Bauteile (10) elektronische Elemente hergestellt werden.

5. Verfahren nach einem der vorangehenden Ansprüche, dadurch gekennzeichnet, daß in die Zwischenbereiche (11) von den einem Bauteil (10) zugeordneten Migrationsbereichen (7) ein von dem Material des Körpers (1) verschiedenes Material (14) eingebracht wird.

6. Verfahren nach einem der vorangehenden Ansprüche, dadurch gekennzeichnet, daß die freigelegten Migrationsbereiche (7) mit einer Beschichtung (12) versehen werden.

7. Verfahren nach einem der vorangehenden Ansprüche, dadurch gekennzeichnet daß auf die Rückseite (4) der freigelegten Migrationsbereiche (7) eine dem jeweiligen Bauteil (10) zugeordnete Abdeckung (15) aufgebracht wird.
